Europäisches Patentamt

European Patent Office

Office européen des brevets

(19)

(11) Publication number: **0 037 900**
**A1**

## (12) EUROPEAN PATENT APPLICATION

(21) Application number: **81101686.4**

(22) Date of filing: **09.03.81**

(51) Int. Cl.³: **G 11 C 19/08**

(30) Priority: **17.03.80 US 130647**

(43) Date of publication of application: **21.10.81**
**Bulletin 81/42**

(84) Designated Contracting States: **DE FR GB IT**

(71) Applicant: **Rockwell International Corporation, 2230 East Imperial Highway, El Segundo, California 90245 (US)**

(72) Inventor: **Gergis, Isoris Sobhi, 5892 Lynnbrook Place, Yorba Linda California (US)**

(74) Representative: **Wagner, Karl H., P.O. Box 246 Gewuerzmuehlstrasse 5, D-8000 München 22 (DE)**

(54) **Two-level major/minor loop organization using current field access for magnetic bubble domain devices.**

(57) A magnetic bubble domain storage organization in which the propagation path is formed by a plurality of current access major loops, each major loop having associated with it a plurality of field access minor loops. A combination of field and current access schemes by which bubbles are propagated in bubble devices are disclosed. The storage area of the device is a field access pattern. A plurality of current access tracks are provided in which bubbles are generated, detected, switched, and otherwise manipulated for the various active functions of the device. The field access part of the device could be conventional Permalloy, ion implanted patterns, or any other field access type structure. The current access part is proposed to be a two-phase type implemented as ion implanted contiguous disks in combination with zigzag type conductor pattern. Such a two-level hierarchical configuration allows much lower power dissipation and faster access time than single level major loop/minor loop organizations.

PF79E80

- 1 -

## TWO-LEVEL-MAJOR/MINOR LOOP ORGANIZATION USING CURRENT FIELD ACCESS FOR MAGNETIC BUBBLE DOMAIN DEVICES

### Technical Field of the Invention

The invention relates to magnetic bubble domain device architecture and in particular to major loop/minor loop configurations using current and field access.

### Background Art

Various types of magnetic bubble domain propagation organization are known in the prior art, including the major loop/minor loop configuration. The major loop/minor loop configuration, such as described in U.S. Patent No. 3,618,054, consists of a plurality of first recirculating "minor" channels and a second "major" channel.

There are also two methods by which bubbles are propagated in bubble devices; one is the usual field access type and the second is the current (or conductor) access type. In field access devices, the propagation tracks are made of regular repetitive patterns of a specific structure, such as Permalloy elements or ion implanted contiguous disks. The pattern provides traveling potential wells in response to a rotating in-plane field. Bubbles, in turn, are propagated by moving with the potential wells. In current access devices, the necessary potential wells are provided by a set of conductor patterns in which polyphase, usually two or three phase, currents are transmitted. The conductors are typically formed in multiple layers, insulated from one another and driven in a two or three phase manner. An example of such a device is described in U.S. Patent No. 3,460,116. It is also known from U.S. Patent No. 3,564,518 to use an elongated conductor loop to cause enlargement of a bubble for detection, which is then detected on collapse.

The combination of field access and current access devices on the same chip is known, for example, from U.S. Patent No. 4,157,591.

Field access devices have the advantages of simplicity of fabrication, very low power dissipation on the chip and tolerance to localized defects in the storage area. One disadvantage of field access devices is slow speed, since generating the drive field at high frequency requires large voltage-current products that limits the practical frequency of operation at about 200 kHz or so. Another disadvantage is that two orthogonal coils are required to generate the rotating in-plane field adding volume and weight to the device package.

Conductor access devices have the advantages of operation at higher frequency than field access and that no field coils are needed. Current access devices will have simpler, lighter and smaller packages. On the other hand, current access devices are therefore more complex to fabricate requiring at least two fine levels of lithography over the whole device area. They are consequently susceptible to certain defects that have catastrophic effect on the device such as electrical shorts between the two conductor levels.

In field access bubble devices, the power dissipation occurs mainly in the coils that provide the drive field of the device. This is typically about 1 watt for 1 cm device area, running at 50 Oe drive at 200 kHz. Alternative bubble technologies such as current access devices where bubbles are propagated either using single phase or two-phase current carrying conductors, the power dissipation is concentrated mostly in the propagation conductors constituting the minor loops. Unlike the field access devices, the minor loops are not required to be activated all the time the device is being accessed since their propagation conductors can be made separate from those of the major loops, the switches, and the detectors. The minor loops can be activated only to bring the desired block of data to the transfer switches connecting them to the major loop (or loops) and once the bubbles are transferred over to the major loop, the drive current in the minor loops are simply shut off. The major loops propagate the bubbles to the input or the output ports of the device for either reading and/or rewriting them. The bubbles are propagated around the major loops back to the transfer-in switches connecting them to the minor loops where the block of data is restored to its original location. In a simple major/minor loop organization of a square chip, the minor loops are activated, on the average, about N steps ($N^2$ is the device bit capacity). The major loop is activated 2N steps (once around the loop). Thus, on the average the power dissipation in the minor loops is only one-third of its peak value. The power dissipation in the major loop being small (there are only 2N cells in the major loops versus $N^2$ cells in the storage loops) contributes very little to the device power dissipation and thus the average device power dissipation is essentially one-third of its peak value.

0037900

- 4 -

## Summary of the Invention

Briefly, and in general terms, the present invention provides a bubble domain device architecture which is a combination of field and current access schemes. The storage area of the device, which occupies more of the device area, is preferably a field access structure. The field access structure is preferably combined with a plurality of current access structures in which bubbles are generated, detected, switched and otherwise manipulated to perform various active functions of the device. The field access portion of the device could be constructed with conventional Permalloy or ion implanted elements or other field access type structure. The current access portion of the device is preferably a two-phase type conductor track.

In the preferred embodiment of the present invention, the device is constructed with ion implanted contiguous disks in combination with a zigzag type conductor pattern.

The novel features which are considered as characteristic for the invention are set forth in particular in the appended claims. The invention itself, however, both as to its construction and its method of operation, together with additional objects and advantages thereof will be best understood from the following description of specific embodiments when read in connection with the accompanying drawings.

- 5 -

Brief Description of the Drawings

FIG. 1 is a top plane view of a zigzag shaped conductor for implementation of a magnetic bubble domain device as is known in the prior art;

FIG. 2 is the potential energy diagram associated with the current access configuration shown in FIG. 1;

FIG. 3 is a combination of a Permalloy rail and the zigzag shaped conductor of FIG. 1 as is known in the prior art;

FIG. 4 is a two-way transfer switch implemented using field access and current access techniques according to the present invention;

FIG. 5 is a timing diagram showing the relative amplitude and the phase of the in-plane magnetic field and the two-phase current for both transfer-out and transfer-in functions in the device shown in FIG. 4;

FIG. 6 is a timing diagram which shows the swap sequence for the device shown in FIG. 4;

FIG. 7a is a transfer switch implemented between two dual conductor current access tracks according to the present invention;

FIG. 7b shows the phase relationship between the currents in the tracks of FIG. 7a under normal propagation conditions;

FIG. 8 is a highly schematic view of a transfer mode in which bubbles are transferred from the S track to the $S_1$ track;

FIG. 9 is a timing diagram of the transfer sequence to effect the transfer as depicted in FIG. 8;

FIG. 10a is a dual conductor replicator device according to the present invention;

FIG. 10b is a timing diagram of the current in the various portions of the device shown in FIG. 10a;

FIG. 11 is a dual conductor stretcher detector according to the present invention;

FIG. 12a is a top plan view of a current access field access bubble generator according to the present invention;

FIG. 12b is a timing diagram of the polyphase currents used in the device shown in FIG. 12a; and

FIG. 13 shows a two-level hierarchical major loop/minor loop organization according to the present invention.

The present invention provides a magnetic bubble domain device architecture in which the propagation path is preferably formed by a plurality of current access major loops, each major loop having associated with it a plurality of field access minor loops. The architecture provides a combination of field and current access schemes by which bubbles are propagated.

The storage area of the device is preferably a field access pattern. A plurality of current access tracks are also provided in which bubbles are generated, detected, switched, and otherwise manipulated for the various active functions of the device. The field access part of the device could be conventional Permalloy, ion implanted patterns, or any other field access type structure. In the present invention it is an ion implanted contiguous disk. The current access part is preferably a two-phase zigzag type conductor pattern.

More particularly, the hybrid current access/field access device according to the present invention preferably comprises a storage area composed of a number of reentrant loops. Connected to these loops on one or both sides are two-phase dual-conductor current access tracks. The connections are in the form of switches (e.g. one or two-way transfer switches). The two-phase major tracks are connected in turn to some other two-phase tracks through switches (again two or one-way transfer or swap switches). A generator or a number of generators are connected to the two-phase current access tracks. Detectors are also connected to the current access tracks either directly or through some switches such as replicator switches. Such a two-level hierarchical configuration allows much lower power dissipation and faster access time than single level major loop/minor loop organizations.

Some of the elements of the hybrid current access/field access device according to the present invention are:

1. field access ion implanted storage loops;
2. current access two-phase dual conductor tracks;
3. transfer switches between field access tracks and current access two-phase dual conductor tracks;

4.  transfer switches between two dual conductor tracks;

5.  a generator compatible with the dual conductors; and

6.  a detector compatible with the dual conductors.

Each of these features of the present invention will be described and illustrated in greater detail.

Description of the Preferred Embodiment

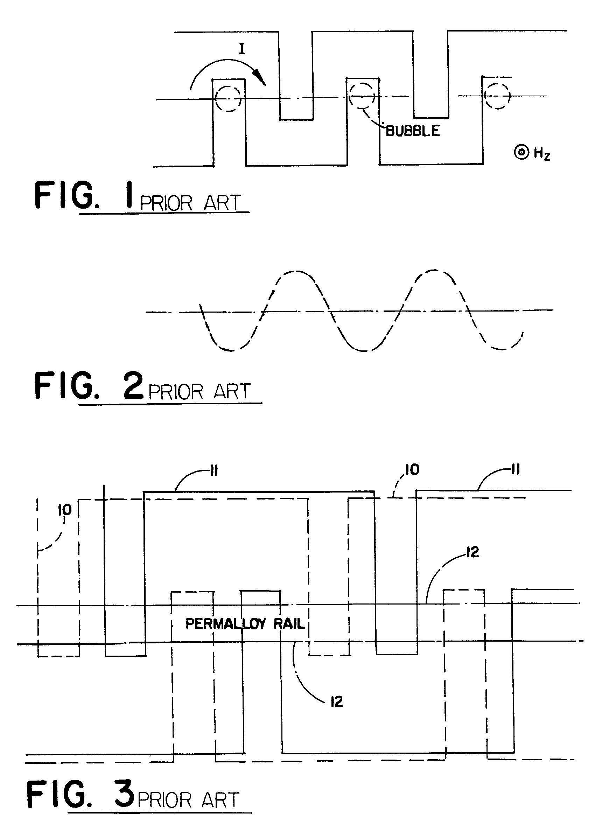

Turning first to FIG. 1 there is shown a top plan view of a zigzag shaped conductor implemented on the surface of a magnetic layer capable of supporting magnetic bubble domains as is known in the prior art. The conductor carrys an electric current and generates a periodic potential energy profile shown in FIG. 2 in the layer of magnetic material. A traveling wave of potential wells can be generated by two such conductors that are spaced 1/4 of a period apart, each conductor being excited by an a-c current which is 90 degrees out of phase with respect to the other. Such a device can thus be used to propagate bubbles. Since the zigzag conductor is an open structure and, thus, the potential energy profile slowly varies in the direction outward of the open portion of the conductor loops, the bubble may escape the propagation track. It is thus advantageous to confine the bubble motion to a well defined channel by some means such as a Permalloy rail that runs in the middle of the conductors.

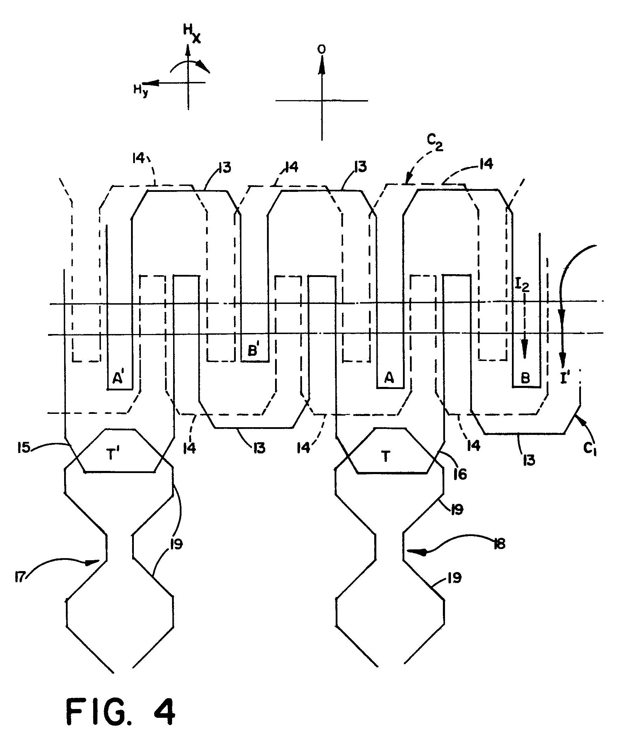

FIG. 3 shows a top plan view of a two-level current-access path with a Permalloy rail as is known in the prior art. The figure shows a lower level first meandering conductor 10 shown as a dotted line and an upper level second meandering conductor 11 shown as a solid line. The two conductors are offset in phase from one another. Along the line of symmetry of both paths is a Permalloy rail 12.

Although the cross-sectional view of the structure is not shown, the Permalloy layer is disposed directly above the planar layer of magnetic material in which the bubble domains are propagated. Above the Permalloy layer is a layer of electrically insulating material, followed by the lower level conductor layer, another layer of insulating material, and the upper level conductor layer. The Permalloy layer can also be used for implementing a Permalloy structure for sensing of bubbles. The use of a Permalloy bubble sensor therefore requires no additional steps in fabricating the hybrid devices as compared to regular ion implanted devices.

Turning now to FIG. 4 there is shown a top plan view of a current access field access magnetic bubble domain device according to the present invention including transfer switches for connecting the current access tracks with a field access track. By utilizing the four independent drives available in these devices, namely the in-plane fields ($H_x$, $H_y$) and the currents in the dual conductors $I_1$, $I_2$, one can achieve many switching functions between the field access and the current access tracks.

FIG. 4 is a top plan view of a two-level current access path with Permalloy rail together with field access tracks connected thereto by a two-way transfer switch. The figure shows a lower level .first meandering conductor track 13 shown in solid line and an upper level second meandering conductor track 14 shown as a dotted line. The lower level first meandering conductor includes extended portions 15, 16, etc., every two periods. The extended portion 15 and 16 each essentially consist of a hairpin type loop which is formed merely by extending one of the loops formed by the meandering conductor 13. Portions of the field-access propagation paths 17 and 18 are disposed adjacent to the extended portions 15 and 16 respectively for transferring magnetic bubble domains therebetween, thereby forming a transfer switch.

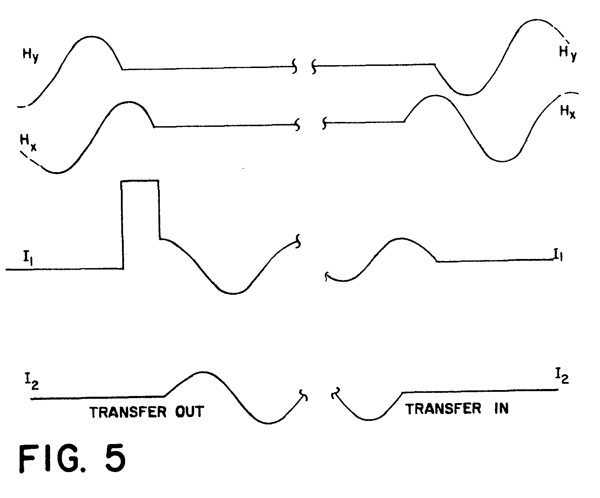

The operation of the two-way transfer switch is as follows. With the bubble in the conductor tracks 14, the in-plane field is permitted to rotate until it reaches orientation 0 i.e., the horizontal direction in the figure at the instant the field $H_y = 0$, and the in-plane field is kept that way until switching is completed. The current $I_1$ is increased while field $H_x$ is decreased so that a field gradient is established to pull the bubble from the tip T of the ion implanted pattern and into the inside of the loop of conductor $C_1$ (location A). Field $H_x$ is then reduced to its normal off value (usually 5 to 8 Oe) and is kept that way until bubbles clear the switch area. Once bubbles are transferred to the dual conductor track, they can be propagated by the current $I_1$ & $I_2$ in the normal fashion. Notice that the switching pulse amplitude applied to $C_1$ could be considerably larger than the amplitude necessary for simple propagation in the conductor tracks. The specific timing of the transfer-out sequence showing the relative amplitude and phase of the drives $H_x$, $H_y$, $I_1$ and $I_2$ as described above is shown in FIG. 5.

The switching-in from the dual conductor track to the ion implanted pattern is performed as follows: the bubble is propagated along the dual conductor track until it reaches location A inside the conductor loop $C_1$ at which time $I_1$ is at its peak and $I_2 = 0$. $I_1$ is decreased and $H_x$ is increased thus establishing a field gradient to pull the bubble to tip T of ion implanted pattern. $H_x$ attained its full amplitude as $I_1 = 0$. The bubble now on the ion implanted pattern is propagated under the influence of $H_x$ and $H_y$ in the normal fashion. The transfer-out and transfer-in sequences for the pattern shown in FIG. 4 is depicted in FIG. 5.

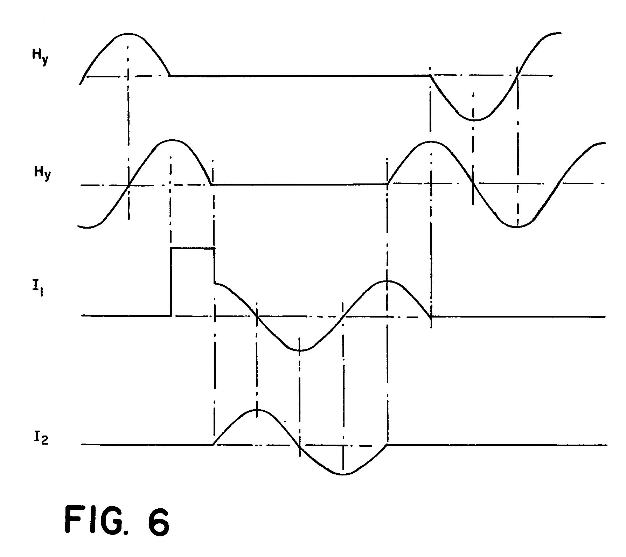

Another switching function that can be performed is the swapping of a stream alternate bit bubbles with a block of data in the storage loops. The fact that propagation in the field and the current access tracks are independent make this a relatively simple operation. In fact, the bubbles in the current access tracks can be swapped with any arbitrary block of data in the storage loops. The rotating field is first activated so that the desired block to be swapped out is located on the tips of the loops T, T', T'', etc. The data to be swapped-in is propagated until the bubbles reach locations B, B', etc. Transfer-out is performed to transfer the bubbles from T to A. The current is activated one cycle to bring the new data to location A. Finally, transfer-in is performed to bring the new data to T and the swap function is thus completed. A timing diagram of the swap sequence to perform such operations for the device shown in FIG. 4 is illustrated in FIG. 6.

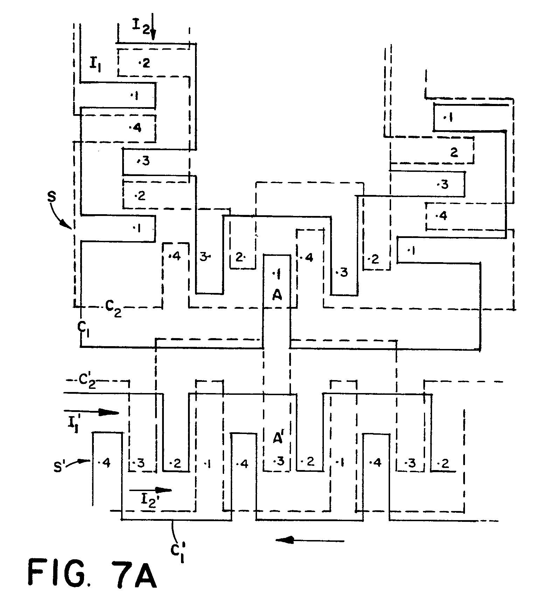

Switching between two current access tracks is made by rearranging the relative phases between the drive currents (there are four independent currents, two in each track). FIG. 7a shows a top plan view of a transfer switch according to the present invention connecting two tracks S and S', each comprising two meandering conductor tracks $C_1$, $C_2$, and $C_1'$, $C_2'$, respectively. The tracks $C_1$ and $C_1'$ are shown by solid lines, and the tracks $C_2$ and $C_2'$ by dotted lines. The Permalloy rails that define the propagation channels are connected at the switch to define the switching channel. Numerals 1, 2, 3, 4, 1', 2', 3', 4', etc. are used to represent sequential positions of bubbles that correspond to the phases of the drive currents indicated by the same numerals. Under normal propagation conditions (no switching) bubbles can propagate in each track independently without interference.

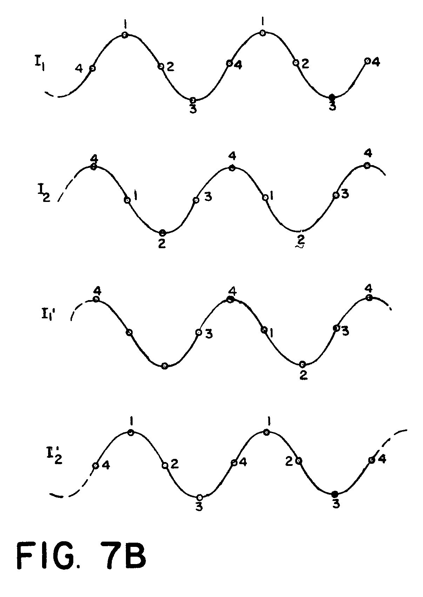

The phase relationship between the drive currents $I_1$, $I_2$, $I_1'$, and $I_2'$ are illustrated in FIG. 7b such that the a-c component of the bias, at the closest points in the two tracks, are out of phase. Corresponding reference numerals 1, 2, 3, 4, 1, 2, etc. are used to represent timing points. In other words, when location A has an attractive pole location A' has a repulsive one and vise-versa.

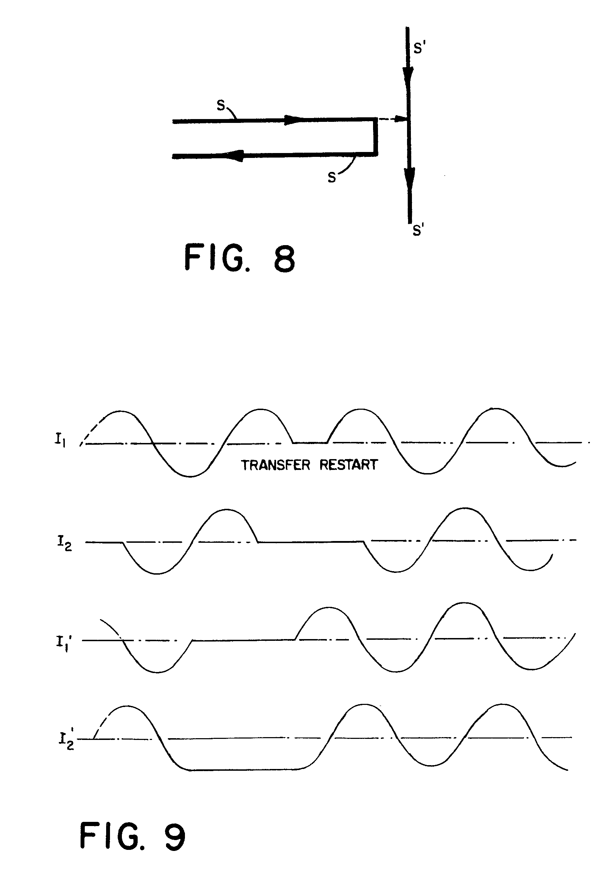

In the transfer mode, such as the one depicted in a highly diagrammatic manner in FIG. 8, the currents $I_1$, $I_2$, $I_1'$, and $I_2'$ are arranged to effect the transfer of bubbles from S to S'. The transfer sequence is made possible by the current timing diagram shown in FIG. 9.

Using the timing sequence shown in FIG. 9, a bubble is propagated in S until it reaches A where $I_1$ is at its positive peak. The currents in S', 180 degrees earlier, were frozen such that A' is attractive. Current $I_1$ is then reduced keeping $I_2 = 0$ so that A' becomes more attractive and the bubble transfers to A'. The bubble is then propagated in S' in the normal fashion. Now, bubbles in S can be left in place for as long as required, or can be propagated again starting with appropriate phase relationship with the currents in S' for independent propagation. The transfer from S' and S is also possible with an analogous timing sequence to the one described above.

A great deal of flexibility exists in this arrangement. Since the two tracks are independently driven it is possible, for example, to transfer a consecutive bit stream in S to alternate bit stream in S' or vice versa. Rearrangement of data can be readily achieved by utilizing the transfer-in and out along with forward and backward propagation. These features are useful in many applications.

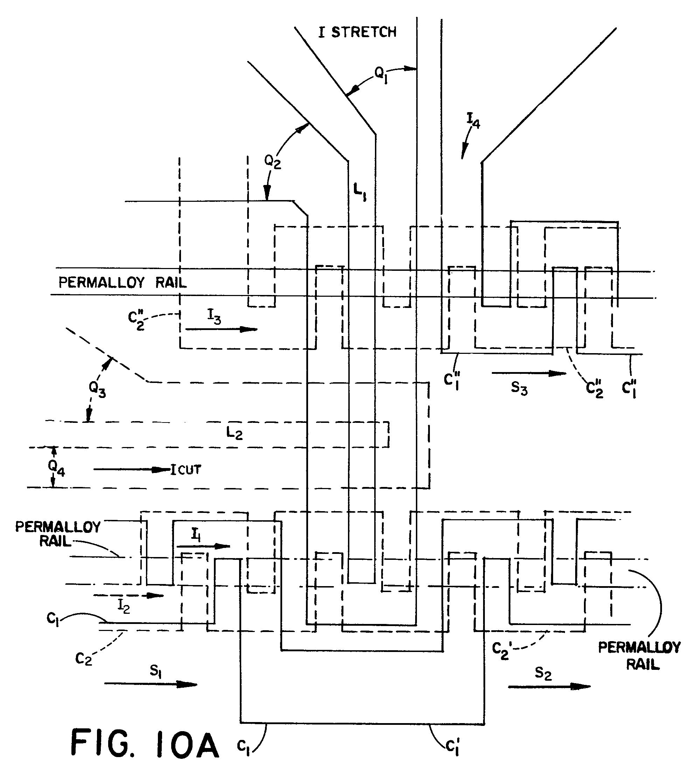

FIG. 10a shows a dual-conductor replicator switch design according to the present invention. Under normal, non-replication operation, bubbles propagating along dual conductor track $S_1$ are transferred to $S_2$ with no switching performed. The activation of the switch results in replicating the bubble from $S_1$ into two bubbles, one bubble proceeding into $S_2$ and the other bubble proceeding to dual conductor track $S_3$.

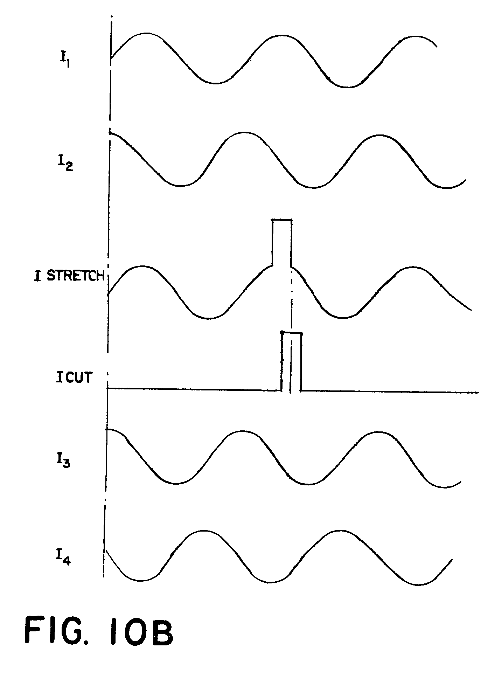

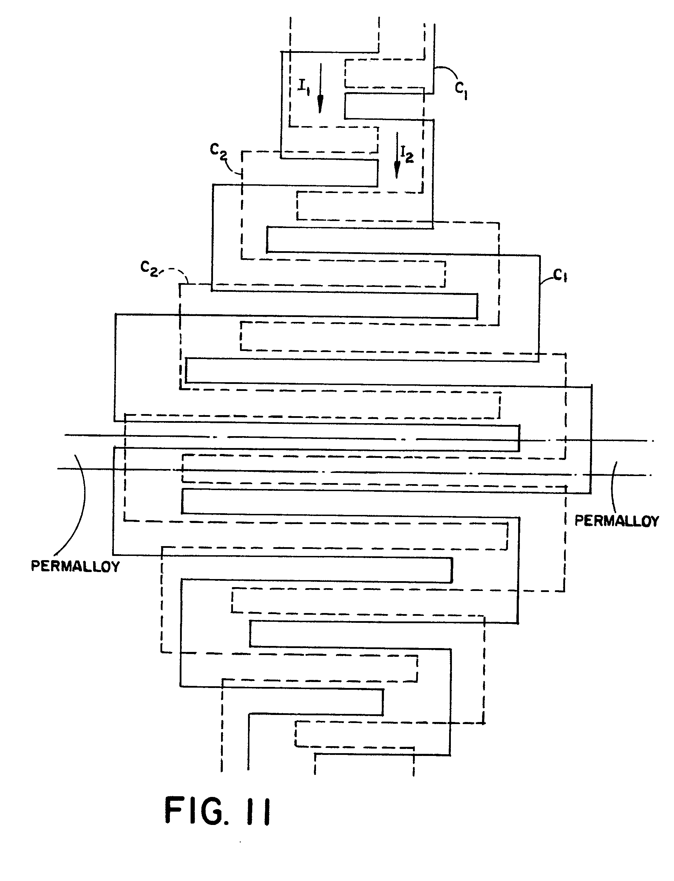

The operation of the replicator switch shown in FIG. 11a is as follows. A current pulse of sufficient duration is supplied to conductor leads $Q_1$ and $Q_2$ such that a strong favorable field is generated inside loop $L_1$ which stretches the bubble from $S_1$ into a stripe domain. With the stretch current still applied, another current pulse is applied to conductor leads $Q_3$ and $Q_4$ to generate

an unfavorable field inside loop $L_2$ which severs the stripe domain into two parts. The lower portion of the severed domain shrinks back into a bubble in track $S_1$ and proceeds towards track $S_2$ as during normal propagation. The second or upper portion of the domain is propagated into track $S_3$. The timing diagram of the currents to perform such replication is depicted in FIG. 10b.

The design of the stretcher-detector according to the present invention is shown in FIG. 11. By using independently driven long loop meandering conductors, a dual-conductor stretcher-detector can be readily realized. The two conductors $C_1$ and $C_2$ are labeled as in the previous figures, with currents $I_1$ and $I_2$ respectively. Gradual stretching and de-stretching can be used for non-desctructive detection, i.e., to retain the bubble after detection. The sense element is made of a thin Permalloy layer, and can be implemented on the same level used for the Permalloy rails in the propagation channels. The magneto-resistance of Permalloy permits the sensing of bubbles as is well known in bubble technology.

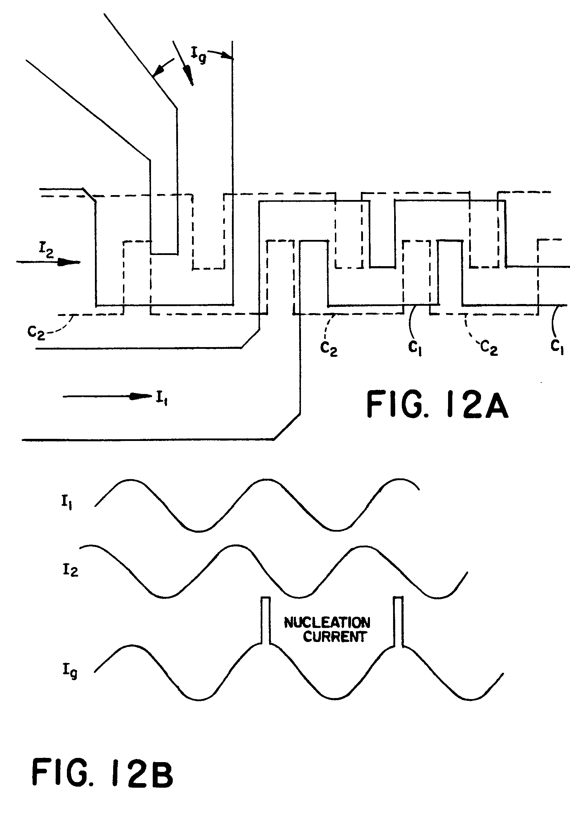

FIG. 12a illustrates a hair pin loop placed adjacent to a dual conductor track used to nucleate (or generate) bubbles according to the present invention. Conductor track $C_1$ with current $I_1$, and track $C_2$ with current $I_2$ is shown, along with the hairpin loop (shown in a solid line) with current Ig. In order to deliver the bubble to the meandering conductor tracks without a loss in the bias margin, the nucleation loop also supplies an a-c field which is synchronized with that in the dual-conductor track. In other words, the current in the loop creates a continuation of the travelling potential well. The timing diagram of the currents in the nucleation loop relative to that in the dual conductors is shown in FIG. 12b. When the amplitude of the current Ig is large enough, as shown in the figure, a bubble is generated which is then propagated down the dual conductor track.

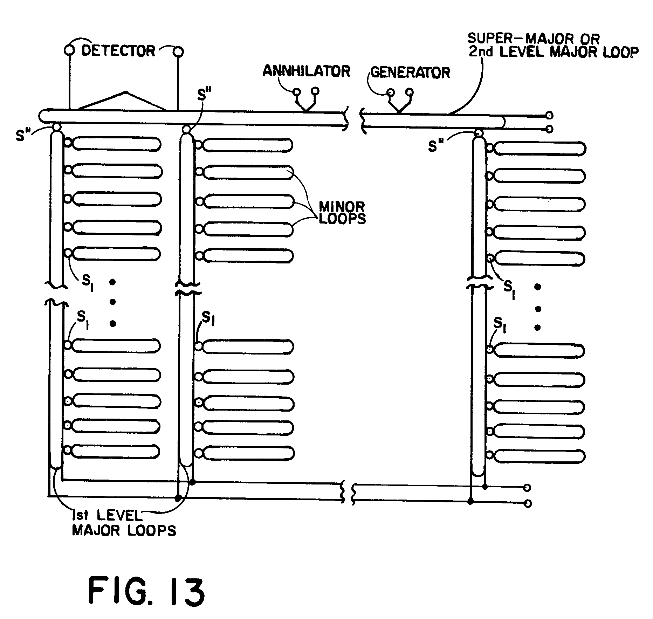

FIG. 13 is a diagrammatic representation of a two-level hierarchical major loop/minor loop organization constructed with a hybrid field access-current access propagation according to the present invention. FIG. 13 illustrates the organization on a square chip (although the present invention is not restricted to that shape) whose dimension on the side is about N circuit periods, so that the total storage capacity is $N^2$ bits. The chip is subdivided into a number (n) of major/minor loop sets. In the figure, three major/minor loop sets are shown. Each set contains $\frac{N}{2}$ minor loops, each has $\frac{2N}{n}$ bits, and a first level major loop whose length is either 2N or N depending on whether the major loop period is equal or is twice as large as the period in the minor loops. Each major loop is connected to the minor loops through two way transfer switches (represented as small circles, $S_1$), the design of which depends on the type of propagation circuit used in the major and the minor loops. Examples of the various switch designs suitable for the different propagation circuits are described above. The first level major loops are in turn connected to a super-major or second level major loop through another set of two-way transfer switches (also represented as small circles S''). The spacing between the switches on the super-major loop is M which could be made equal to $\frac{N}{n}$ but not necessarily so. The input (generator) and the output (detector) ports of the devices are located on the super-major loop. The minor loops, the first level major loops and the second level major loops are assumed to be operated independently of each other in fact, major and super-major loops could be current accessed and the minor loops could be field accessed, or alternatively all of the loops could be current accessed. The following discussion will apply equally to these two embodiments.

Although a two-level hierarchical organization is shown in FIG. 13, the present invention is not intended to be limited to such. The arrangement of a three-level or n-level hierarchical organization is also within the scope of the present invention, as are architectures other than hierarchical ones.

Returning now to the embodiment in FIG. 13, data is stored naturally in the form of blocks, each contains $\frac{nN}{2}$ bits distributed among all the minor loops, one bit each. Each block, by virtue of the chip, is subdivided into a number of sub-blocks each containing $nM$ bits. To access a sub-block of data $(B_{11})$ contained in a block $(B_1)$, the minor loops are activated, on the average $\frac{N}{n}$ steps, until $(B_1)$ reaches switches $S_1$. $B_1$ is transferred to the first level major loops, which in turn are activated on the average $\frac{N}{2}$ steps, until $B_{11}$ reaches $S''$. Switching is performed at $S''$ to transfer $B_{11}$ to $Maj._{11}$ which is subsequently propagated to the detector, then to the annihilator and to the generator where the data can be altered, if necessary. $B_{11}$ is continued to be propagated around the super major loop until it reaches $S''$, meanwhile the major loop is activated, so that $B_{11}$ can be restored to its original position in $B_1$ (still located in $Maj._1$). $B_1$ can now be restored into the minor loops via $S'$ by the reverse of the previously described sequence.

When comparing the power dissipation of different devices, the comparison should be made taking into consideration the difference in their data rate. In other words, the comparison should be made between the energy dissipation in accessing and restoring a specific number of bits. Denoting the power dissipation in the minor and the major and super-major loops by $P_1$ and $P_2$, and their frequency of operation by $f_1$ and $f_2$ respectively, the energy per bit per step is:

- 17 -

$$\varepsilon_1 = \frac{P_1}{f_1} \; , \quad \varepsilon_2 = \frac{P_2}{f_2}$$

To reduce the power dissipation, the minor loops are made shorter relative to the major loops. This can be implemented in a square chip, or nearly square chip, by combining several major/minor loop sets into the two-level major/minor loop chip architecture. The power reduction is achieved due to the reduction in the part of the operating cycle during which the minor loops are activated. In the two level major/minor loop organization, the average energy dissipated in accessing and restoring a sub-block of data is:

$$(E_{total})_1 = N^2 \cdot \frac{N}{n} \cdot \varepsilon_1 + 2 \cdot N \cdot \frac{N}{2} \cdot \varepsilon_2 + N \cdot N \cdot \varepsilon_2 + M \cdot n \; \varepsilon_{det}$$

$$= \frac{N^3}{n} \; \varepsilon_1 + 2N^2 \; \varepsilon_2 + Mn \; \varepsilon_{det} \qquad (1)$$

First term in the equation above is the dissipation in activating the minor loops whose capacity is $N^2$ a number of steps $= \frac{N}{2}$. The second term is the energy dissipated in activating a major loop (capacity N) a $\frac{N}{2}$ steps once to propagate $B_{11}$ to S'' and the second time to run the reverse sequence also $\frac{N}{2}$ steps. The third term is the dissipation in the super major loop (capacity N) to run N steps. The last term is the dissipation in the detector assumed activated to a high current level only during the detection of a block of length nM.

- 18 -

We now calculate the energy dissipation in accessing and restoring a block of data (size $\frac{N}{2}$) in $N^2$ capacity chip with simple major/minor loop organization.

$$(E_{cycle})_2 = N^2 \cdot N \cdot \varepsilon_1 + N \cdot N \, \varepsilon_2 + \frac{N}{2} \cdot \varepsilon_{det}$$

$$= N^3 \, \varepsilon_1 + N^2 \, \varepsilon_2 + \frac{N}{2} \, \varepsilon_{det} \qquad (2)$$

The first term is the dissipation in the minor loops activated N steps and the second term is the dissipation in the major loop activated N steps and the detector dissipation is the last term.

In an all-current access device $\varepsilon_1 = \varepsilon_2 \simeq 1.0$ picojoules and $\varepsilon_{det}$ is $4 \times 10^4$ picojoules. In a 1 M bit chip (N = 1000) and the chip dissipation in the detector and in the major loops are of the order of $10^{-3}$ that of the minor loops. Comparing (1) and (2), we find the ratio between the energy dissipation in the two level major/minor loop is $\frac{1}{n}$ that of the single major/minor loop organization. This is a considerable savings in the power of the memory system where a number of bubble devices are run in parallel to achieve large data rate output.

The same savings occurs in hybrid type device (field/current) where $P_1 = 1\mu$ watts and $f_1 = 200$ kHz giving $\varepsilon_1 = 5$ picojoules. Again the power dissipation is dominated by that of the minor loops and the factor of reduction is $\frac{1}{n}$. It is also worth noting that the energy dissipation in a hybrid organization will also be considerably smaller than the all-field access type.

The next look at the access time in the proposed organization. The average time it takes for a sub-block of data to reach the detector access time is given by

$$T_{acc} = \frac{N}{n} t_1 + \frac{N}{2} t_2 + nMt_2$$

where $t_1$, and $t_2$ are the period of time of bubble propagation in the minor and the major loops, respectively.

The time required to access and restore (cycle time) a sub-block of data is equal to

$$T_{cycle} = \frac{N}{n} t_1 + N t_2 + 2 nMt_2$$

As an illustration, consider a 1 M bit chip where $N = 1000$, and $n = 10$, and $M = \frac{N}{n} = 100$. In the case where the minor, major, and super major loops are all current accessed at a rate of, say 1 M Herz per second $t_1 = t_2 = 1$ μsec

$$T_{acc} = 100 + 500 + 1000 = 1600 \text{ μsec}$$

We also consider the case where the minor loops are field accessed at a rage of 200 kHz/sec., i.e., $t_1 = 5$ μsec.

$$T_{acc} = 2000 \text{ μsec}$$

We compare above to the case of an all-field accessed 1 M bit device with a simple major/minor loop organization.

$$T_{acc} = N t_1 + \frac{N}{2} t_1 = 1500 t_1 = 7500 \text{ μsec.}$$

It is thus clear that this organization enhances the performance of the field/current access devices as compared to an all-field access one. In fact, the access in such a device is only slightly longer than an all-current access device. This advantage is, of course, in addition to the significant reduction in the device power dissipation as described above.

- 20 -

While the invention has been illustrated and described as embodied in a  two-level-major/minor loop organization using current field access for magnetic bubble domain devices, it is not intended to be limited to the details shown, since various modifications and structural changes may be made without departing in any way from the spirit of the present invention.

It will be obvious to those skilled in the art that the magnetic bubble device according to the present invention can be manufactured with various lithographic technologies and different combinations of known process steps, and that the preferred embodiments illustrated here are merely exemplary.  The composition, configuration, and distance between the guide elements, as well as their distance to the magnetic bubble layer, can be chosen depending upon the properties desired.  These and other variations can be further elaborated by those skilled in the art without departing from the scope of the present invention.

The present invention is also not restricted to the specific magnetic materials and circuits described.  For example, it may be pointed out that magnetic materials other than garnet, for example hexagonal ferrites or various crystalline compounds may be used.  Moreover, the source, orientation, and frequency of the magnetic fields and electrical currents, and the static or dynamic nature of the signals applied to the device may be suitably selected as desired for a particular application.

- 21 -

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention, and, therefore, such adaptations should and are intended to be comprehended within the meaning and range of equivalence of the following claims.

The invention may be summarized as follows:

1.  A magnetic bubble domain system comprising:

a planar layer of magnetic material in which magnetic bubble domains can be propagated;

a bubble domain guide structure coupled to said layer for guiding the movement of said bubble in said layer; said guide structure being organized into a super-major loop, a plurality of major loops suitably positioned for transfer of domains between said super-major loop and said major loops, and a plurality of minor loops suitably positioned for transfer of domains between said major loops and respective ones of said minor loops.

2.  A system as defined in item 1, wherein a portion of each of said major loops is located adjacent said super-major loop for transfer of domains therebetween.

3.  A system as defined in item 1, wherein a portion of each of said minor loops is located adjacent said major loop for transfer of domains therebetween.

4.  A system as defined in item 1, further comprising transfer gates disposed between said super-major loop and said major loop, and said major loop and respective ones of said minor loops.

5.  A system as defined in item 1, wherein said minor loops are formed by a field access structure.

6.  A system as defined in item 5, wherein said field access structures comprise ion-implanted contiguous disks.

7.  A system as defined in item 1, wherein said major loops are formed by current access structures.

8.  A system as defined in item 1, wherein said super-major loops are formed by current access structures.

9. A system as defined in item 7 or 8, wherein said current access structures comprise meandering conductor means.

10. A system as defined in item 9, wherein said meandering conductor means comprise a first meandering conductor having a predetermined frequency with a first phase disposed in a first layer above said layer of magnetic material, and a second meandering conductor having said predetermined frequency of said first meandering conductor but a different phase disposed in a second layer above said first layer and insulated therefrom.

11. A system as defined in item 1, further comprising means coupled to said body for generating and controllably positioning magnetic domains in said magnetic material.

12. A magnetic bubble domain system comprising:

a planar layer of magnetic material in which magnetic bubble domains can be propagated;

a first bubble domain guide structure coupled to said layer and defining a first bubble propagation path for guiding the movement of said bubbles in said layer in response to a cyclical change in orientation of a rotary magnetic field within the plane of said layer;

a second bubble domain guide structure coupled to said layer and defining a second propagation path for guiding the movement of said bubbles in said layer in response to the phase of a current applied to said guide structure;

characterized in that said first propagation path forms a bubble storage section and said second bubble propagation path forms an input and output section.

13. A system as defined in item 12, wherein said first propagation path comprises a plurality of minor loops and said second propagation path comprises a major loop.

14. A system as defined in item 12, wherein said first propagation path comprises ion-implanted contiguous disks.

15. A system as defined in item 12, wherein said second propagation path comprises a dual conductor track.

16. A system as defined in item 15, wherein said second propagation path further comprises a Permalloy rail disposed over said dual conductor track.

17. A magnetic arrangement comprising:

a layer of material in which magnetic bubble domains can be moved;

a pattern of first elements responsive to a magnetic field reorienting cyclically through at least first and second consecutive half cycles in the plane of said layer for moving said domains, said first pattern defining a first channel;

a second pattern of second elements responsive to an electrical current pulse for moving said domains, said second pattern defining a second channel, and an exchange position therebetween, said exchange position including a portion of one of said elements in each of said associated channels;

said elements in each of said channels being operative in response to a particular combination of an orientation of said magnetic field and a phase of said current pulse for moving a domain from a first position in a first channel to a second position in said second channel.

18. An arrangement as defined in item 17, wherein said pattern of first elements comprises ion-implanted contiguous discs.

19. An arrangement as defined in item 17, wherein said pattern of second elements comprises a dual conductor track.

20. A magnetic bubble domain system comprising:

a layer of material in which magnetic bubble domains representative of data can be moved;

a periodic pattern of elements for defining a first, second, and third recirculating channels in which domains move in response to external drive means, said first and said second channels, and said second and said third channels coming into close proximity at exchange positions;

at least one of said channels being a field access propagation path, and at least one of said channels being a current access propagation path.

21. A system defined in item 20, wherein said external drive means comprises an external magnetic field reorienting cyclically in the plane of said layer, and a current source for providing a periodically varying electrical current to one of said channels.

22. A magnetic bubble domain system comprising:

a first current access propagation path composed of a periodic pattern of substantially identical elements;

a second field access propagation path including a portion adjacent to said first propagation path and forming an exchange position therebetween;

a transfer element different from said identical elements and included in said first propagation path and adjacent to said portion of said second propagation path; and

transfer means coupled to said layer for transferring a domain between said first and said second propagation paths at said exchange position.

23. A system as defined in item 22, wherein said first current access propagation path comprises a meandering conductor having a portion forming a hairpin loop.

24. A system as defined in item 22, wherein said first current access propagation path is a dual conductor track.

25. A system as defined in item 24, wherein said transfer element comprises a first portion of the upper conductor of said first propagation path which overlies a first portion of a contiguous disc of said second propagation path.

26. A magnetic bubble domain system including a layer of magnetic material in which magnetic bubble domains representative of data can be moved along first and second channels which come into close proximity and include an exchange position therebetween, said arrangement also including transfer means coupled to said layer at said exchange position for transferring a domain between said first and said second channels, characterized in that said transfer means comprises means for providing a specific combination of an orientation of an external magnetic field in the plane of said layer, and a current pulse applied to said layer.

27. A magnetic bubble domain device comprising a layer of magnetic material in which magnetic bubbles can be moved, and means for moving magnetic bubbles in the layer, the means comprising first and second layers of electrically conducting material spaced apart and insulated from each other and defining at least first and second paths for moving magnetic bubbles therealong in response to a first pulse sequence impressed in the layers, the device being characterized in that the first and second layers include an intersecting hairpin loop for defining a transfer location responsive to a second pulse sequence to move a bubble from the first to the second path.

28. A magnetic bubble domain device as defined in item 27, wherein said first and second paths are dual conductor tracks.

29. A switch for magnetic bubble domain devices comprising:

a first current access propagation path;

a second current access propagation path including a portion adjacent to said first propagation path;

a transfer region included in a portion of said first propagation path and a portion of said second propagation path; and

means coupled to said body for controllably transferring a magnetic bubble in a first portion of said transfer region on one of said propagation paths to a second portion of said transfer region on the other of said propagation paths.

30. A switch as defined in item 29, wherein said first current access propagation path is a dual conductor track.

31. A switch as defined in item 29, wherein said second current access propagation path is a dual conductor track.

32. A switch as defined in item 29, wherein a first and a second spaced-apart portion of the upper conductor of said first propagation path overlies a first and a second spaced-apart portion of the lower conductor of the second propagation path.

33. A switch as defined in item 29, wherein said transfer region comprises an elongated rectangular shape in which the opposed ends are positions of lowest energy for bubbles propagating along the first and second propagation paths respectively.

34. A replicator switch for magnetic bubble domain devices comprising:

a first current access propagation path;

a second current access propagation path including a portion adjacent to said first propagation path;

a transfer region disposed between said first and second propagation paths;

a first hairpin loop conductor extending between a portion of said first current access propagation path and a portion of said second current access propagation path;

a second hairpin loop conductor disposed adjacent said first hairpin loop conductor in said transfer region and functioning to cut a bubble extending between said first and said second propagation paths through said transfer region upon activation.

35. A replicator switch as defined in item 34, wherein said first and said second current access propagation paths are dual conductor tracks.

36. A replicator switch as defined in item 34, wherein said first hairpin loop conductor is an upper level conductor.

37. A replicator switch as defined in item 34, wherein said second hairpin loop conductor is a lower level conductor.

38. A replicator switch as defined in item 34, wherein said first and said second hairpin loop conductors are essentially disposed at right angles with respect to one another in said transfer region.

39. A replicator switch as defined in item 34, wherein said first hairpin loop conductor functions to stretch a bubble propagating on said first current access propagation path between said first current access propagation path and said second current access propagation path.

0037900

40. A stretcher detector for magnetic bubble domain devices comprising:

a first current access propagation path including dual conductor tracks taking the shape of square waves characterized in that the amplitude of the square wave pattern gradually increases to a maximum at a predetermined region of said chip and thereupon decreases to the normal amplitude, wherein a Permalloy detector is disposed over said dual conductor track for detecting the presence of magnetic bubble domains in said specified region of said layer.

41. A generator for magnetic bubble domain devices comprising:

a first current access propagation path;

a hairpin loop adjacent one end of said first current access propagation path for forming a bubble to be propagated along said propagation path.

Claims

1. A magnetic bubble domain system comprising:

a planar layer of magnetic material in which magnetic bubble domains can be propagated;

a bubble domain guide structure coupled to said layer for guiding the movement of said bubble in said layer; said guide structure being organized into a super-major loop, a plurality of major loops suitably positioned for transfer of domains between said super-major loop and said major loops, and a plurality of minor loops suitably positioned for transfer of domains between said major loops and respective ones of said minor loops.

2. A system as defined in claim 1, wherein a portion of each of said major loops is located adjacent said super-major loop for transfer of domains therebetween.

3. A system as defined in claim 1, wherein a portion of each of said minor loops is located adjacent said major loop for transfer of domains therebetween.

4. A system as defined in claim 1, further comprising tr. isfer gates disposed between said super-major loop and said major loop, and said major loop and respective ones of said minor loops.

5. A system as defined in claim 1, wherein said minor loops are formed by a field access structure.

6. A system as defined in claim 5, wherein said field access structures comprise ion-implanted contiguous disks.

7. A system as defined in claim 1, wherein said major loops are formed by current access structures.

8. A system as defined in claim 1, wherein said super-major loops are formed by current access structures.

9. A system as defined in claim 7 or 8, wherein said current access structures comprise meandering conductor means.

10. A system as defined in claim 9, wherein said meandering conductor means comprise a first meandering conductor having a predetermined frequency with a first phase disposed in a first layer above said layer of magnetic material, and a second meandering conductor having said predetermined frequency of said first meandering conductor but a different phase disposed in a second layer above said first layer and insulated therefrom.

I

BUBBLE

⊙ Hz

**FIG. 1** PRIOR ART

**FIG. 2** PRIOR ART

11

10

10

11

12

PERMALLOY RAIL

12

**FIG. 3** PRIOR ART

FIG. 4

3/12        0037900

FIG. 5

$H_y$

$H_y$

$I_1$

$I_2$

FIG. 6

FIG. 7A

# FIG. 7B

FIG. 8

FIG. 9

FIG. 10A

9/12

0037900

I₁

I₂

I STRETCH

ICUT

I₃

I₄

FIG. 10B

FIG. 11

**FIG. 12A**

**FIG. 12B**

FIG. 13

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | G 11 C 19/08 |
| X | NEUES AUS DER TECHNIK, no. 2, 1st. April, 1977, index no. 390; Vogel Verlag K.G. WUERZBURG (DE) "Speicher mit magnetischen 'Bubble'-Domänen"<br><br>* The whole article *<br>--- | 1-5, 7,8 | |
| | JOURNAL OF APPLIED PHYSICS, vol. 50, no. 3, March 1979, NEW YORK (US) BONYHARD: "A novel major/minor loop bubble memory chip organization for high performance without block replication", pages 2213-2215<br><br>* From page 2214, left-hand column, line 46 to the end of the article; figures 1C and 1CC *<br>--------- | 1-4 | |

**TECHNICAL FIELDS SEARCHED (Int. Cl.³)**

G 11 C 19/08

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 25.06.1981 | DEGRAEVE |

EPO Form 1503.1 06.78